# EUROPEAN PATENT APPLICATION

(11) **EP 4 173 824 A1**
(43) Date of publication of application: **03.05.2023**
(21) Application number: 21205242.7
(22) Date of filing: 28.10.2021
(51) Int. Cl.: B33Y 10/00, B33Y 30/00, B33Y 70/00, G03F 7/00, G03F 7/029, G03F 7/031, G03F 7/20

(54) **PHOTORESIST COMPOSITION, SYSTEM COMPRISING A PHOTORESIST COMPOSITION, METHOD FOR PRODUCING A THREE-DIMENSIONAL STRUCTURE, AND USE OF A PHOTORESIST COMPOSITION IN 3D-PRINTING**

(71) Applicant: Karlsruher Institut für Technologie, 76131 Karlsruhe (DE)
(72) Inventor: Hahn, Vincent, 76131 Karlsruhe (DE); Wegener, Martin, 76227 Karlsruhe (DE); Messer, Tobias, 76139 Karlsruhe (DE)
(74) Representative: Müller-Boré & Partner Patentanwälte PartG mbB

(57) **Abstract**

An aspect of the present invention relates to a photoresist composition, comprising: (A) a polymerizable monomer, (B) a photoinitiator, and optionally (C) a polymerization inhibitor, wherein the photoinitiator has at least the following electronic quantum mechanical energy states: (i) a ground state, (ii) a substantially optically excitable first intermediate state, and (iii) an optically excitable polymerization-inducing state, wherein the first intermediate state is energetically located above the ground state and below the polymerization-inducing state and has a lifetime of about 100 ps to 10 s, and the polymerization-inducing state is optically excitable from the first intermediate state by a single-photon excitation of a predetermined wavelength. Further aspects relate to a system comprising a photoresist composition, a method for producing a three-dimensional structure and a use of a photoresist composition in 3D-printing.

## Description

The present invention relates to a photoresist composition, a system, in particular for 3D-printing, comprising a photoresist composition, a method for producing a three-dimensional structure, and a use of a photoresist composition in 3D-printing.

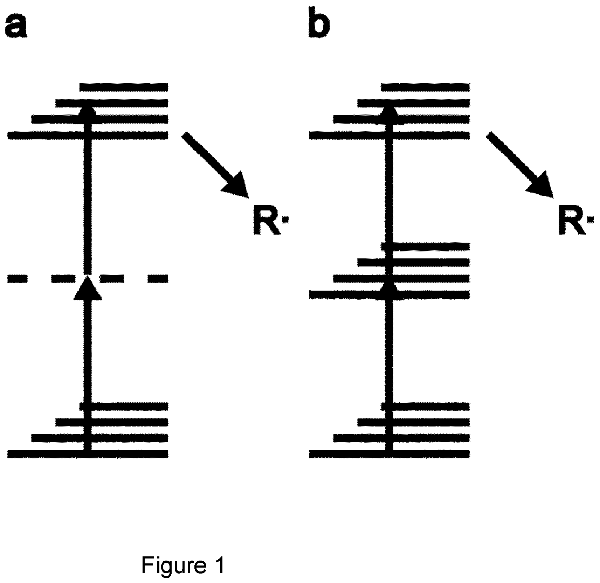

In her PhD thesis, Marie Göppert-Mayer brought two-photon absorption to light. In a two-photon absorption process illustrated in Fig. 1, the light field induces a state in between the ground state and a relevant excited state of a quantum system, e.g., a molecule. This induced state (see dashed line in Fig. 1a), or dressed state in the language of quantum optics, is commonly referred to as a virtual state. This state really exists, but only as long as the light field is switched on. When using a laser pulse, the virtual state lifetime is determined by the pulse duration. Intuitively, a first photon induces the transition of an electron from the ground state to the virtual state, from which a second photon induces the transition to the excited state.

Today, two-photon absorption processes are crucial in multiphoton optical microscopy and multiphoton optical lithography, both of which have been commercially available for many years. Multiphoton optical lithography has become a well-established method to fabricate three-dimensional (3D) structures from the nano- to the microscale. In 3D optical lithography aka direct laser writing or 3D laser nanoprinting, two-photon absorption leads to a scaling of the photoinitiator transition rate and hence of the exposure dose proportional to *l*², i.e., the light intensity squared. Critically, this quadratic nonlinearity suppresses unavoidable lateral and axial tails of the diffraction-limited laser focus and thereby warrants the crucial concentration of the excitation and the following chemical reaction along all three spatial directions. Importantly, one-photon absorption alone without additional nonlinearities fundamentally cannot provide this concentration in the making of arbitrary 3D structures. To obtain efficient two-photon absorption, mode-locked pico- or femtosecond laser sources are routinely used. Upon diffraction-limited focusing, peak intensities in the range of *l* = 10¹² W/cm² and the corresponding photon irradiance of 3.10³¹ s⁻¹cm⁻² (at a wavelength of 800 nm) provide appreciably large effective cross sections in the range of 10⁻¹⁹-10⁻²⁰ cm², depending on the photoinitiator molecule.

While being a well-established technology, using femtosecond lasers to obtain efficient two-photon absorption in 3D laser nanoprinting has a number of conceptual and practical drawbacks.

First, when increasing the laser power from the point of sufficient polymer crosslinking upwards, micro-explosions occur due to the onset of three- and four-photon absorption processes and beyond, leading to the unwanted population of high-energy electron states. Typically, the laser power at which micro-explosions occur is less than an order of magnitude above the writing point. Sometimes, the process window is even as small as 10%. Small pollutions or dirt microparticles in the photoresist can trigger micro-explosions even at the writing point. Such events render entire time-consuming 3D-printing jobs useless.

Second, the required femtosecond laser oscillators are still extremely costly.

Third, the femtosecond laser and its supply take up a considerable volume fraction of the overall instrument. This combination of cost and size has so far prevented 3D laser nanoprinters to become anywhere close to as ubiquitous as graphical 2D laser printers or other forms of optics-based 3D-printers.

Thus, a problem to be solved by the present invention is to improve 3D-printing.

This problem is solved by the independent claims. Preferred embodiments result from the respective dependent claims.

An aspect of the present invention relates to a photoresist composition, comprising:
(A) a polymerizable monomer,
(B) a photoinitiator, and optionally
(C) a polymerization inhibitor,

wherein the photoinitiator has at least the following electronic quantum mechanical energy states:
   (i) a ground state,
   (ii) a substantially optically excitable first intermediate state, and
   (iii) an optically excitable polymerization-inducing state,
wherein the first intermediate state is energetically located above the ground state and below the polymerization-inducing state and has a lifetime of about 100 ps to 10 s, and
the polymerization-inducing state is optically excitable from the first intermediate state by a single-photon excitation of a predetermined wavelength.

Advantageously, the above-mentioned photoresist composition contributes to miniaturization of 3D-microprinting and 3D-nanoprinting devices, herein also referred to as 3D-printing devices, and renders 3D-printing more cost-efficient. Moreover, the photoresist composition provides a comparable transition rate scaling regarding the intensity of light *l* from the ground state to the polymerization-inducing state of /*^{N}* with *N>1,* where *N*=2 as in the case of two-photon absorption-based 3D-printing, or, more generally speaking, where *N*≥2 as in the case of multiphoton absorption-based 3D-printing. As a result, the photoresist composition enables more efficient 3D-printing while maintaining high printing resolution. Using the above-mentioned photoresist composition in 3D-printing, three-dimensional micro- and/or nanostructures may be printed, being extendable to large scale structures.

All the drawbacks of state-of-the-art 3D-printing as mentioned above may be prevented.

According to the present invention, the term "polymerizable monomer" is not particularly restricted and may include one type of polymerizable monomer or may include a mixture of two or more polymerizable monomers. Also, the type of polymerization monomer is not limited and may, for example, include monomers suitable for radical polymerization, cationic or anionic polymerization, as well as monomers following specific polymerization mechanisms such as thiol-ene-based or thiol-yne-based polymerization, or Diels-Alder cycloaddition.

Examples of polymerizable monomers include acrylates, methacrylates, acrylamides, methacrylamides, styrenes and other vinyl compounds, alkenes including dienes, alkynes, lactones, lactams, (cyclic) amines, and thiols.

The expression "photoinitiator" used herein is not particularly restricted and includes such compounds which create reactive species such as radicals, cations or anions upon irradiation with light, for example of the UV, VIS or IR wavelength range. These reactive species are then capable of initiating and/or promoting polymerization of the polymerizable monomer.

According to the present invention, the term "polymerization inhibitor" is not particularly restricted and used in a general sense to describe any compound capable of preventing unwanted polymerization. As such, the term "polymerization inhibitor" as used herein includes both retarders and true inhibitors. This may also include singlet or triplet state quenchers.

In quantum physics or quantum chemistry, electronic quantum mechanical energy states or quantum states normally refer to a set of quantum numbers, such as energy level number and spin, which describe the dynamics of electrons in a quantum system such as an atom or a molecule. Quantum states mathematically refer to wavefunctions which are determined as solutions of the Schrödinger equation of an atom or a molecule. The electronic quantum states may, in the framework of this description, be single-particle states or wavefunctions of the electrons of an atom or a molecule. These single-particle states may be solutions of the Schrödinger equation for the electrons of an atom or a molecule using a mean-field approximation of the electrostatic interactions of the electrons as, for example, in the so-called Hartree-Fock approach or density functional theory. The single-particle states of the electrons obtained in such a way may be atomic orbitals or molecular orbitals.

In this respect, the term "ground state" refers to the energetically highest single-particle state, i.e., atomic or molecular orbital, that an electron of the photoinitiator may have or - in quantum chemistry language - occupy below or at room temperature. The term "intermediate state" refers to an orbital which is higher in energy than the ground state. The term "polymerization-inducing state" refers to an orbital higher in energy than the intermediate state, which when occupied by an electron by excitation of the electron from the ground state or intermediate state induces the polymerization of the polymerizable monomers in the photoresist composition. By occupying the polymerization-inducing state or orbital by exciting an electron, a chemical reaction resulting in the polymerization of the polymerizable monomers of the photoresist composition is activated or sets in.

In this description, the term "optically excitable state" refers to an electronic quantum state or orbital which may be reached or occupied by light excitations, i.e., by electron-photon interactions, such as electron-photon scattering processes. An electron may be excited by being hit by a photon and/or absorbing the photon of a specific wavelength and/or frequency corresponding to the excitation energy from the previous state to the optically excitable state.

The term "substantially optically excitable state" refers to the situation that a state to be excited may be occupied only by an optical excitation by an electron-photon hit and/or exciting an electron by absorbing a photon, or the state to be excited may be occupied by an optical excitation of an electron to a metastable state from which the electron may then relax to the state to be excited.

In this description, the term "lifetime" means the time until an electron relaxes from a state to an energetically lower state or the time after which a state is de-occupied by an electron. The relaxation process or de-occupying process may be a radiation-free process or may occur by radiation. That is, an electron may emit a photon of an energy corresponding to the energy difference between the metastable state and the state to be excited when relaxing from the metastable state to the state to be excited.

The lifetime may be about 80 µs. The lifetime may also be in the range of about 1 µs to about 10 ms.

Advantageously, the lifetime of the first intermediate state is long enough so that the first intermediate state can be populated using low optical powers, simultaneously, short enough so that after an exposure, the photoinitiator molecules outside the focal region quickly return to their ground state and subsequent focal regions may be exposed in rapid succession, as described further below in more detail. More generally, it is advantageous that the amount of photoinitiator molecules excited to the first intermediate state always stays small compared to the amount of photoinitiator molecules in the ground state, i.e., it is advantageous that there is no population inversion.

The term "single-photon excitation" refers to excitations which are caused by hitting an electron by one single photon and/or absorbing the photon by the electron. To excite an electron by one single photon, the photon needs to have a specific wavelength and/or frequency corresponding to the excitation energy of the electron, i.e., the energy difference between an initial state and the state to be excited.

In a specific embodiment, the polymerization-inducing state may be optically excitable by at least two sequential single-photon excitations of substantially the same predetermined wavelength.

Advantageously, in the aforesaid embodiment, the photoresist composition provides a comparable nonlinear transition rate scaling regarding the intensity / from the ground state to the polymerization-inducing state of /² as in the case of two-photon absorption-based 3D-printing. As a result, the photoresist composition enables 3D-printing at high resolution and/or high printing velocity. By using the photoresist composition in 3D-printing, the spatial localization of optical excitations may be increased, whereby the resolution of 3D-printing may be improved.

The term "substantially the same" means that the wavelengths of the two subsequent photons causing the sequential two single-photon excitations may absolutely differ by about 0%, by utmost about 1%, by utmost about 5%, by utmost about 10%, or by utmost about 20%. However, in principle, it is also possible that the wavelengths of the two subsequent photons causing the sequential two single-photon excitations differ by more than about 20%.

The two sequential single-photon excitations may herein also be referred to as two-step absorption. Three sequential single-photon excitations may be referred to as three-step absorption. Four sequential single-photon excitations may be referred to as four-step photon absorption, and so on.

The aforementioned respective terms may be used interchangeably.

In a specific embodiment, the predetermined wavelength may be at least about 300 nm and/or utmost about 900 nm. The predetermined wavelength may also be at least about 400 nm and/or utmost about 800 nm. The predetermined wavelength may be about 405 nm, about 440 nm, about 488 nm, about 532 nm, or about 640 nm.

Additionally or alternatively, the single-photon excitation may have a predetermined frequency of at least about 0.3 PHz and/or utmost about 1 PHz. The single-photon excitation may also have a frequency of at least about 0.375 PHz and/or utmost about 0.75 PHz. The frequency may be about 0.74 PHz, about 0.68 PHz, about 0.61 PHz, about 0.56 PHz, or about 0.47 PHz.

Additionally or alternatively, the single-photon excitation may be of at least about 1.24 eV and/or utmost about 4.14 eV. The single-photon excitation may also be of at least about 1.55 eV and/or utmost about 3.11 eV. The single-photon excitation may be of about 3.07 eV, about 2.82 eV, about 2.53 eV, about 2.32 eV, or about 1.95 eV.

The wavelength may be the wavelength of the light emitted by a laser used in a Blu-ray player, a DVD player, a Blu-ray writing device, a DVD writing device, or a laser pointer.

The first intermediate state may be a real state.

In a specific embodiment, the first intermediate state may be a relaxed state with respect to an energetically higher state being optically excitable from the ground state by a single-photon excitation of the predetermined wavelength.

In this embodiment, the first intermediate state may be a state which is reachable by an intersystem crossing of the photoinitiator. The first intermediate state may be a state of different orientation of total spin or spin multiplicity than the energetically higher state. The first intermediate state may, for example, be a triplet state, whereas the energetically higher state may be a singlet state.

The photoinitiator may comprise multiple intermediate states as described above. All features described with respect to the first intermediate state apply to each of the multiple intermediate states.

The photoinitiator may have a second intermediate state energetically lower than the first intermediate state and lower than the polymerization-inducing state, wherein the second intermediate state may be substantially optically excitable from the ground state, and wherein the first intermediate state may be optically excitable from the second intermediate state based on a single-photon excitation of substantially the predetermined frequency.

The photoinitiator may have a third intermediate state energetically lower than the second intermediate state and lower than the polymerization-inducing state, wherein the third intermediate state may be substantially optically excitable from the ground state, and wherein the second intermediate state may be optically excitable from the third intermediate state based on a single-photon excitation of substantially the predetermined frequency, and so on.

The photoinitiator may have a linear, molar extinction coefficient in the ground state of about 0.1 to about 1000 M⁻¹ cm⁻¹ at the predetermined wavelength. The photoinitiator may have a linear, molar extinction coefficient in the ground state of about 50 M⁻¹ cm⁻¹ at the predetermined wavelength.

The photoinitiator may have a linear, molar extinction coefficient in at least one of the multiple intermediate states of about 10 to about 100 000 M⁻¹ cm⁻¹ at the predetermined wavelength. The photoinitiator may have a linear, molar extinction coefficient in at least one of the multiple intermediate states of about 5000 M⁻¹ cm⁻¹ at the predetermined wavelength.

The multiple intermediate states may have an energy of utmost about 70 kcal/mol. The multiple intermediate states may have an energy of utmost about 60 kcal/mol.

Advantageously, thereby, bond cleavage reactions may be prevented.

At least one of the multiple intermediate states may be inert.

In a specific embodiment, the photoinitiator may be selected from the group consisting of alpha-diketones such as benzil, beta-diketones, gamma-diketones, spiropyrans, merocyanines, carbazoles, thiophenes, polycyclic aromatic hydrocarbons, triketones, photoenoles, (di-)acylgermanes, bis(germyl)ketones, and thioxanthones.

In a specific embodiment, the polymerization inhibitor may be selected from the group consisting of 2,2,6,6-tetramethyl-4-piperidyl-1-oxyl (TEMPO) and derivatives thereof, bis(2,2,6,6-tetramethyl-4-piperidyl-1-oxyl) sebacate (BTPOS) and derivatives thereof, other hindered amine light stabilizers (HALS), 1,4-diazabicyclo[2.2.2]octane (DABCO), n-propyl gallate (NPG), p-phenylenediamine (PPD), cyclodextrines, phenothiazines, hydroxylamines, quinones, mequinol, 4-tert-butylcatechol (TBC), butylated hydroxytoluene (BHT), nitrobenzenes, phenol, p-nitrophenol, stilbenes, galvinoxyl, and azulene.

In a specific embodiment, the content of the photoinitiator may be 0.1% to 10% by weight based on the photoresist composition. Additionally or alternatively, the content of the polymerization inhibitor may be 0.05% to 10% by weight based on the photoresist composition.

The photoinitiator may have a plurality of absorption bands at at least about 300 nm and utmost about 900 nm. The photoinitiator may have a plurality of absorption bands at at least about 400 nm and utmost about 800 nm. The photoinitiator may have at least one absorption band at about 405 nm and/or about 440 nm and/or about 488 nm and/or about 532 nm and/or about 640 nm. The plurality of absorption bands may overlap.

Another aspect of the present invention relates to a system, in particular for 3D-printing, comprising:
a photoresist composition according to the above-described aspect or any one of the specific embodiments, and
at least one continuous-wave light source for irradiating the photoresist composition,
the system optionally further comprising:
   a focusing unit for focusing the light emitted by the at least one continuous-wave light source on the photoresist composition, and
   a positioning unit for controlling the position of the focusing unit with respect to the position of the photoresist composition.

Advantageously, the aforesaid system allows for cost-efficient and highly accurate 3D-printing, in particular on the scale of micrometers and/or nanometers, being extendable to larger scales. Furthermore, the system may be manufactured in a more compact fashion.

In a specific embodiment, the at least one continuous-wave light source may comprise a laser and/or a light emitting diode. The at least one continuous-wave light source may be a laser and/or a light emitting diode. The at least one continuous-wave light source may comprise or be a laser used in a Blu-ray player and/or a DVD player and/or a Blu-ray writing device and/or a DVD writing device and/or a laser pointer. The at least one continuous-wave light source may also comprise or be any suitable lamp, for example a mercury vapor lamp, a metal-halide lamp, or the like.

The at least one continuous-wave light source may comprise or be a non-pulsed laser. The at least one continuous-wave light source may include quasi continuous-wave light sources which are continuous-wave light sources that may be periodically interrupted.

In a specific embodiment, the light emitted by the at least one continuous-wave light source may have a wavelength of at least about 300 nm and/or utmost about 900 nm. The predetermined wavelength may also be at least about 400 nm and/or utmost about 800 nm. The predetermined wavelength may be about 405 nm, about 440 nm, about 488 nm, about 532 nm, or about 640 nm.

Additionally or alternatively, the light emitted by the at least one continuous-wave light source may have a frequency of at least about 0.3 PHz and/or utmost about 1 PHz. The light emitted by the at least one continuous-wave light source may also have a frequency of at least about 0.375 PHz and/or utmost about 0.75 PHz. The frequency may be about 0.74 PHz, about 0.68 PHz, about 0.61 PHz, about 0.56 PHz, or about 0.47 PHz.

The at least one continuous-wave light source may have an optical power of about 1 mW or larger. The at least one continuous-wave light source may also have an optical power in the range of about 1 mW to about 1 W, e.g., about 100 mW. The at least one continuous-wave light source may further have an optical power of about 1 W or larger.

The optical power of the at least one continuous-wave light source may be at least large enough to trigger the polymerization reaction inside the spatial location of the focus of the emitted light. For example, the optical power used for irradiating the photoresist composition in the spatial location of the focus of the emitted light may be about 1 mW or smaller, 100 µW or smaller, or 50 µW or smaller, without, however, being limited thereto.

The at least one continuous-wave light source may include 1, 2, 3, 4, 5, 6, 7, 8, 9 or 10 continuous-wave light sources.

The system may further comprise a focusing unit for focusing the light emitted by the at least one continuous-wave light source on the photoresist composition. Specifically, the focusing unit focuses the light emitted by the at least one continuous-wave light source and sets a first spatial location of the focus of the emitted light, wherein the first spatial location of the focus corresponds to a volume element of the photoresist composition.

The focusing unit may comprise one or more of the following: a collimator, a plano-convex lens, a pinhole, a mirror, a polarizer, and an objective lens.

The system may also further comprise a positioning unit for controlling the position of the focusing unit with respect to the position of the photoresist composition. Specifically, the positioning unit spatially controls the focus of the emitted light such that the focus of the emitted light is movable from the first spatial location to a second spatial location of the focus, wherein the second spatial location of the focus corresponds to a second volume element of the photoresist composition, wherein the first volume element is substantially different from the second volume element. Positioning may be accomplished by moving the focusing unit and/or by moving the photoresist composition.

Herein, the focus of the light emitted by the at least one continuous-wave light source refers to a spatial region, also referred to herein as focal region, in which the light intensity and/or light power of the light emitted by the at least one continuous-wave light source is focused or concentrated. The focal region may be substantially two-dimensional. It may also be three-dimensional.

The first volume element and the second volume element may each correspond to the focal region. The first volume element and the second volume element may also overlap.

The positioning unit may comprise a mirror arrangement and/or a stage. The stage is where the photoresist composition may be positioned. The mirror arrangement may comprise one or more fixed mirrors, and/or one or more motorized mirrors. The motorized mirrors may be piezoelectric, galvanometric or MEMS (micro-electro-mechanical systems) actuated mirrors. The stage may be motorized and may comprise stepper or servo motors, or piezoelectric, voice coil, or other magnetic actuators. The positioning unit may comprise fixed and/or motorized mirrors, and/or a fixed and/or motorized stage.

The system may be a confocal microscope.

Yet another aspect of the present invention relates to a method for producing a three-dimensional structure, wherein the method comprises the following steps:
providing a photoresist composition according to the above-described aspect or any one of the specific embodiments, and
causing polymerization in at least a partial volume of the photoresist composition by irradiating the at least partial volume by means of at least one continuous-wave light source.

Advantageously, by this method, a three-dimensional structure, in particular on the micro- and/or nanoscale, being extendable to larger scales, may be produced or manufactured with high resolution and in a cost-efficient and resource-saving manner.

The method may for example be performed as follows:
In a first step, the photoresist composition may be provided by placing or positioning it on a stage of a system according to the above-mentioned respective aspect or any one of the specific embodiments.

In a second step, at least one of the at least one continuous-wave light sources is switched on to irradiate at least a partial volume of the photoresist composition which initiates the polymerization of the polymerizable polymers comprised by the photoresist composition.

The at least partial volume may be a volume element in which the light intensity and/or light power of the light emitted by the at least one continuous-wave light source is focused or concentrated. The at least partial volume may be a volume element corresponding to the focal region of the light emitted by the at least one continuous-wave light source. The at least partial volume may also be the total volume of the photoresist composition.

In a specific embodiment, the method may further comprise removing an unpolymerized and/or incompletely polymerized remaining volume of the photoresist composition, wherein the polymerized at least partial volume of the photoresist composition may correspond to the three-dimensional structure.

The three-dimensional structure may be on the scale of micrometers and/or nanometers, being extendable to larger scales.

In case of negative-tone photoresists, the removing may include wet-chemical removing of the unpolymerized and/or incompletely polymerized remaining volume of the photoresist composition in a development solution. In case of positive-tone photoresists, the removing may include wet-chemical removing of the solubilized volume of the photoresist composition in a development solution.

In a specific embodiment, the step of causing polymerization may further include exciting the polymerization-inducing state of the photoinitiator of the photoresist composition by at least two sequential single-photon excitations of substantially the same predetermined wavelength.

Advantageously, in this embodiment, a three-dimensional structure may be produced with high resolution. The two-sequential single-photon excitations are spatially localized so that the resolution in producing the three-dimensional structure may be increased.

The above-described method may be performed by means of the above-described system according to the respective aspect or any one of the specific embodiments.

The step of causing polymerization may include irradiating a first volume element of the at least partial volume of the photoresist composition by focusing, by means of the focusing unit, the light emitted by the at least one continuous-wave light source on the first volume element.

The step of causing polymerization may further include moving, by means of the positioning unit, the spatial location of the focus of the light emitted by the at least one continuous-wave light source such that a second volume element spatially different from the first volume element is irradiated.

As already mentioned above, the first volume element and the second volume element may each correspond to the focal region of the light emitted by the at least one continuous-wave light source. The first volume element and the second volume element may also overlap.

Yet another aspect of the present invention is a use of a photoresist composition according to the above-described aspect or any one of the specific embodiments in 3D-printing.

Advantageously, by using the photoresist composition in 3D-printing, a three-dimensional structure, in particular on the microscale and/or nanoscale, being extendable to larger scales, may be produced or manufactured with high resolution, thereby allowing for small minimal feature sizes, in a cost-efficient and resource-saving manner.

In the following, the drawings are described. The drawings provide further explanations and show specific embodiments of the present invention. Individual features depicted in the drawings may be combined to yield further embodiments. In the drawings, it is shown:
- Fig. 1:: 3D laser nanoprinting using two-photon absorption or two-step absorption.
- Fig. 2:: Simplified energy-level model and rate-equation calculations for a two-step absorption.
- Fig. 3:: Benzil as two-step absorption photoinitiator.
- Fig. 4:: Effective nonlinearity of a photoresist composition according to an embodiment of the present invention.
- Fig. 5:: Two-step absorption printing resolution in two and three dimensions.
- Fig. 6:: Gallery of oblique-view electron micrographs of 3D-printed nanostructures.
- Fig. 7:: Chemical structure of bis(2,2,6,6-tetramethyl-4-piperidyl-1-oxyl) sebacate (BTPOS).
- Fig. 8:: Scanning electron micrographs of 3D-printed line gratings with different grating periods.
- Fig. 9:: Laser power versus exposure time for a photoresist composition.
- Fig. 10:: Top-view scanning electron micrograph of attempts to 3D-print woodpile structures.
- Fig. 11:: Spectrum of the laser diode emission at the operating temperature of *T*_{Diode} = 25 °C.
- Fig. 12:: Ground state extinction spectrum of BTPOS in acetonitrile.
- Fig. 13:: Overview of 3D laser polymer printing using (quasi-)continuous-wave lasers.
- Fig. 14:: Sketch of a system according to an embodiment of the present invention.
- Fig. 15:: List of 3D-printing parameters.

In the following, the terms "photoresist composition" and "photoresist" may be used interchangeably.

Fig. 1 shows 3D laser nanoprinting using two-photon absorption or two-step absorption. Fig. 1a shows a schematic energy-level diagram of a canonical two-photon absorption process exciting an electron from a photoinitiator ground state to an excited state with subsequent radical (R·) formation. The dashed horizontal line indicates the intermediate virtual state. Fig. 1b shows the same energy-level diagram, but for two-step absorption instead of two-photon absorption. Here, a real intermediate electronic state is used instead of a virtual intermediate state in two-photon absorption.

In two-photon lithography illustrated in Fig. 1a, an electron population of the initiatormolecule excited-state starts a chemical reaction, which, in negative-tone photoresists, leads to the local crosslinking and hence to the local solidification of a liquid monomer in a small volume element called the voxel (in analogy to the two-dimensional picture element, the pixel). Under high-numerical-aperture focusing conditions, this voxel has a full width at half maximum (FWHM) of utmost about 1 µm in all three spatial dimensions. Scanning of the laser focus according to a predefined path in three dimensions, followed by a development process which washes out insufficiently cross-linked material, yields the wanted 3D micro- or nanostructure.

The basic idea of two-step absorption shown in Fig. 1b is to replace the virtual state in two-photon absorption in Fig. 1a by a real state, i.e., by an intermediate electronic state that exists without the light field. Its lifetime is typically determined by nonradiative processes and can be orders of magnitude longer than femto- or picoseconds. This difference implies three important aspects. First, the efficiency of converting two photons into an excited-state electron population increases with the ratio of the real-state lifetime to the virtual-state lifetime. This ratio can be extremely large. Second, the real-intermediate-state lifetime *τ* = *k_{D}⁻¹,* the inverse of the real-intermediate-state decay rate, introduces a characteristic timescale into the overall process, which means that the exposure time is not scalable as it is in ideal two-photon absorption.

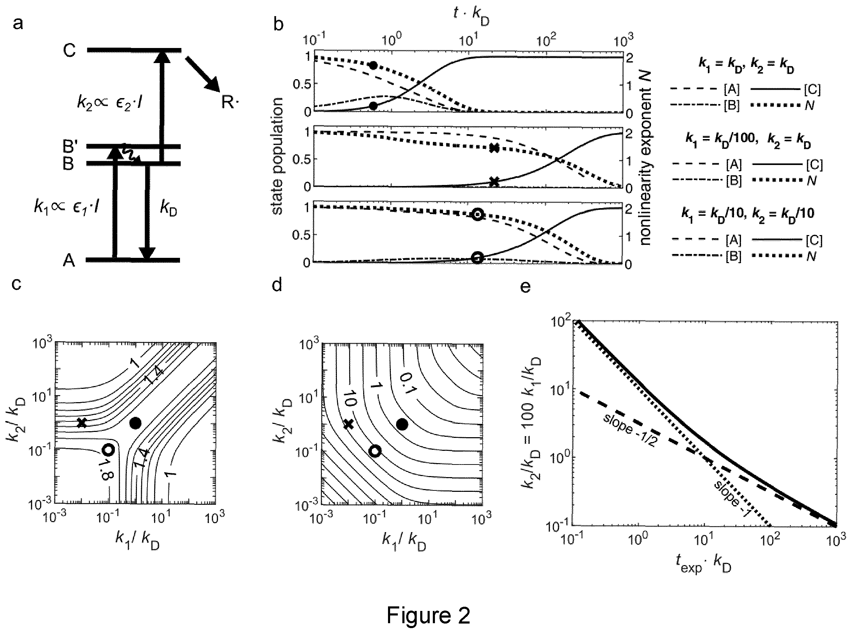

Fig. 2 shows a simplified energy-level model and rate-equation calculations for a two-step absorption photoinitiator. Fig. 2a shows energy levels, with ground state A, intermediate states B and B', and upper state C. We assume a rapid nonradiative decay from B' to B. Radicals (R·) are rapidly generated from a population of energy level C, leading to the dose *D.* At *t =* 0, the ground state population is 1, all other states are initially unpopulated. The rate coefficients *k*₁ ∝ *∈*₁*I* and *k*₂ ∝ *∈₂I* are proportional to the respective state's extinction coefficient and the laser intensity *I*. Fig. 2b shows a temporal evolution of the states' population (left axis) and the nonlinearity exponent *N* (right axis) for three exemplary chosen parameter sets, as defined in the legends. The markers (dots, crosses, circles) indicate the exposure time *t*ₑₓₚ at which the threshold condition is met (we choose *D* = 0.1). For early times, the upper state population increases according to *D* ∝ *t*₂*I*² (hence, *N =* 2). For *t·k*_{D} > 10, we have *D* ∝ *tI*² (hence, *N =* 2). Fig. 2c shows a logarithmic plot of the exponent *N* versus *k*₁/*k*_{D} and *k*₂/*k*_{D}. Fig. 2d shows a normalized exposure time *t*ₑₓₚ*k*_{D} versus *k*₁/*k*_{D} and *k*₂/*k*_{D}. The markers refer to the three conditions defined in Fig. 2b. Fig. 2e shows a threshold intensity *I*, expressed in terms of *k*₂*lk*_{D}*,* versus *t*ₑₓₚ*k*_{D} for *D =* 0.1 and *∈*₂/∈₁ = 100.

We illustrate the more complex behavior of two-step absorption by the rate-equation calculations for the simplified energy-level model in Fig. 2a. The continuous-wave excitation with intensity *I* starts at time *t*=0. The intensity enters into the two transition rates *k*₁ ∝ *∈*₁*I* and *k*₂ ∝ *∈*₂*I,* with the extinction coefficients *∈*₁ and *∈*₂. We refer these rates and time to *k*_{D} to obtain a universal representation. For early times (Fig. 2b), *tk*_{D} « 1, the occupation of the upper level and hence the dose *D* starts according to *D* ∝ *t₂I².* At times *tk*_{D} ≈ 10, the behavior turns over into *D* ∝ *tI².* Note that, for both regimes, the dose scales ∝ *I^{N}* with exponent *N =* 2. (For comparison, a relation *D* ∝ *tI* is expected for one-photon absorption, and *D* ∝ *tI²* for two-photon absorption.) We calculate the general exponent from the logarithmic derivative *N =* d log(D) / d log(*I*) = *(I*/*D)* (d*D*/d*I).* Its dependence on *k*₁/*k*_{D} and *k*₂/*k*_{D} is shown in Fig. 2c, the corresponding exposure time in Fig. 2d. Fig. 2e summarizes the dependence of *I* versus exposure time *t*ₑₓₚ for fixed dose *D* = 0.1 and for *∈*₂/*∈*₁ = 100. We will come back to this dependence in our experiments below. Third, in two-step absorption, unlike for two-photon absorption, an electron in the intermediate state may already trigger a polymerization reaction. It is of utmost importance that we suppress such trigger because this process would correspond to polymerization by ordinary one-photon absorption.

Fig. 2a shows a sketch of an energy-level model for two-step absorption, with ground state A, intermediate states B and B', and upper state C. We assume rapid nonradiative decay between B and B'. Radicals are rapidly generated from a population of energy level C, leading to the dose *D* = [C]. The initial population at *t =* 0 is [A] = 1, [B] = 0, and [C] = 0. Accordingly, the governing rate equations are d[A]/dt =-*k*₁[A]+*k*_{D}[B], d[B]/dt = +*k*₁[A]-*k*_{D}[B]-k₂[B], and d[C]/dt = +*k*₂[B], with *k*₁ and *k*₂ being the transition rate coefficients from state A to state B and from state B to state C, respectively. Here, *k*_{D} is the intermediate-state B decay rate coefficient - the inverse of the intermediate state lifetime *τ*. This differential equation system is solved analytically using Mathematica to obtain explicit expressions for the functions [A](t), [B](t), and [C](t) (see Figs. 2b and 2c). The results shown in Figs. 2d and 2e have been computed by numerical searches of zero crossings using Matlab.

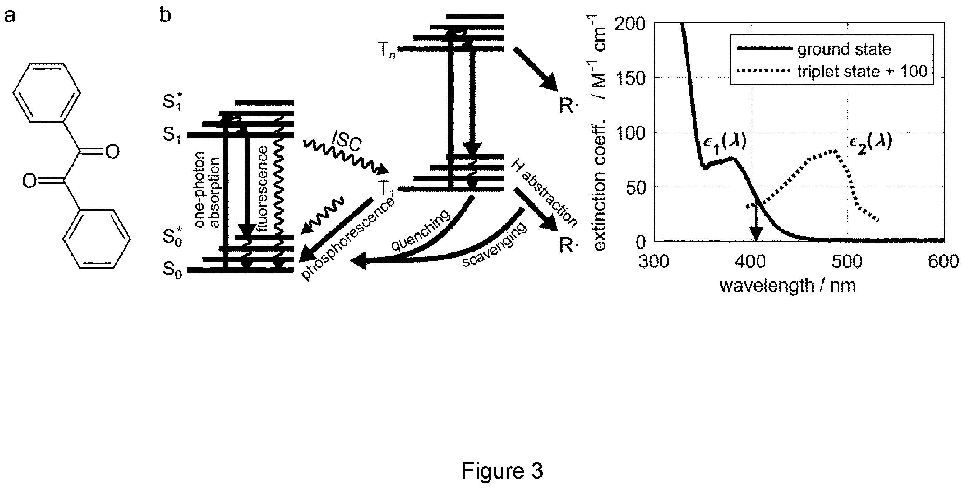

Fig. 3 shows benzil as two-step absorption photoinitiator. Fig. 3a shows a benzil photoinitiator molecule used here. Fig. 3b shows the corresponding Jablonski diagram. The real intermediate state in Fig. 1b is replaced by the excited state singlet manifold, S₁, and the ground state triplet manifold, T₁. As usual, intersystem crossing (ISC) quickly brings electrons from S₁ to T₁. A polymerization inhibitor (BTPOS) suppresses unwanted reactions starting from the occupation of the T₁ state. The second step in two-step absorption brings an electron from the T₁ state to an excited triplet manifold Tₙ from where radicals (R·) are generated, starting the polymerization reaction. Fig. 3c shows measured ground state extinction and flash photolysis triplet excitation spectra of benzil in benzene.

For benzil shown in Fig. 3a, the two-step absorption photoinitiator molecule used here, a Jablonski diagram is depicted in Fig. 3b. As in Fig. 2a, the real intermediate energy level in Fig. 1b is replaced by two nearby real intermediate levels, the singlet S₁ and the triplet T₁ state. Intersystem crossing brings electrons from the S₁ to the T₁ state within a few nanoseconds. The quantum efficiency of this nonradiative process is 92%. Fig. 3c shows the ground state molar decadic extinction and the excited-state extinction spectra of benzil in solution. The wavelength of 405 nm (see arrow) lies in the tail of both spectral maxima and therefore allows for mediating both types of transitions. However, the ground state extinction is about 100 times lower than the triplet-state extinction. This has two attractive consequences. First, at typical photoinitiator concentrations, the photoresist is sufficiently transparent over distances of about 300 µm, i.e., over typical free working distances of microscope objective lenses. This allows for dip-in 3D laser nanoprinting. Second, due to the relatively high transient extinction, even moderate intensities are sufficient to promote a considerable fraction of triplet-excited molecules to a higher excited triplet state.

For Norrish Type I photoinitiators, radicals are generated by fragmentation of molecules into radicals by cleaving chemical bonds, with typical bond energies being above 3 eV (69 kcal/mol). The triplet ground state energy of benzil *E*_{T1} = 2.3 eV (54 kcal/mol), is well below that energy. For efficient bond scission from the triplet state, the triplet energy must be higher than the bond energy. Hence, benzil has been referred to as "reluctant" Norrish type I initiator - which has been our motivation for investigating benzil as a candidate for two-step absorption in the first place. However, benzil, as well as other alpha-diketones, readily abstracts hydrogen atoms from its triplet ground state. This leads to an undesired one-photon triggered polymerization reaction.

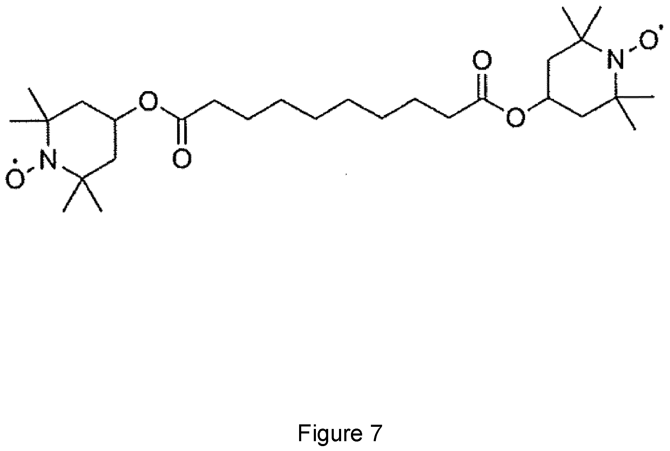

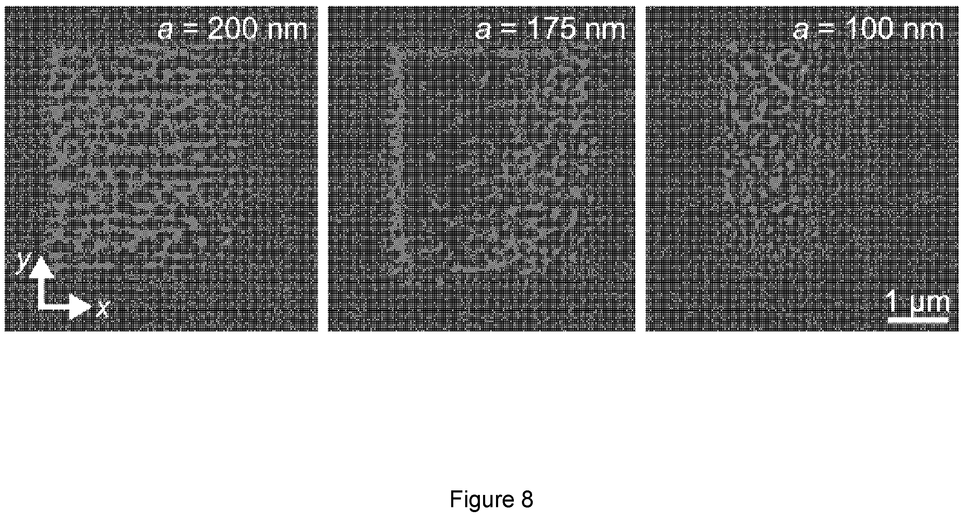

In addition to the two-step photoinitiator, the photoresist compositions used here and abbreviated as PR1 to PR4 in what follows, contain bis(2,2,6,6-tetramethyl-4-piperidyl-1-oxyl) sebacate (BTPOS) (see Fig. 7) as a polymerization inhibitor. BTPOS consists of two linked 2,2,6,6-tetramethyl-4-piperidyl-1-oxyl (TEMPO) moieties. Due to its persistent radical effect, TEMPO is commonly used in nitroxide-mediated radical polymerization. Furthermore, TEMPO can suppress the undesired hydrogen abstraction initiated from an electron in the benzil triplet T₁ state, which may otherwise occur and lead to unwanted radicals initiating the polymerization reaction (see Fig. 8). This initiation would be based on a one-photon process. In addition, TEMPO favorably lowers the lifetime of the intermediate T₁ state. Therefore, the concentration of TEMPO (or BTPOS) is a design parameter in the photoresist composition. Moreover, the photoresists PR1, PR2 and PR4 contain pentaerythritol triacrylate (PETA) as the monomer. Although the monomer contains a hydroxy group, which is prone to hydrogen abstraction, a sufficient suppression of the photoinitiator triplet-state hydrogen abstraction reaction by BTPOS could be achieved. In the photoresist PR3, PETA was replaced by a similar monomer, trimethylolpropane triacrylate (TMPTA), which does not possess a hydroxy group. For the dip-in photoresist PR2 reported below, further components are added for refractive-index matching.
PR1: Benzil (21.0 mg, 100 µmol) and BTPOS (25.6 mg, 50 µmol) are dissolved in 1 ml PETA. This corresponds to 1.7 wt% benzil and 2.1 wt% BTPOS. The mixture is stirred on a hot plate at a temperature of 45 °C for 4 hours until all compounds have dissolved.
PR2: Benzil (21.0 mg, 100 µmol) and BTPOS (25.6 mg, 50 µmol) are dissolved in a 1 ml mixture of IP-DIP NPI (Nanoscribe GmbH & Co. KG) and PETA (70 vol% and 30 vol%). This corresponds to 1.8 wt% benzil and 2.2 wt% BTPOS. The ratio of IP-DIP NPI and PETA is chosen to obtain a diffraction-limited focus. The mixture is stirred on a hot plate at a temperature of 45 °C for 4 hours until all compounds have dissolved.
PR3: Benzil (21.0 mg, 100 µmol) and BTPOS (25.6 mg, 50 µmol) are dissolved in 1 ml TMPTA. This corresponds to 1.8 wt% benzil and 2.2 wt% BTPOS. The mixture is stirred on a hot plate at a temperature of 45 °C for 4 hours until all compounds have dissolved.
PR4: Irgacure 369 (18.3 mg, 50 µmol) and BTPOS (12.8 mg, 25 µmol) are dissolved in 1 ml PETA. This corresponds to 1.5 wt% Irgacure 369 and 1.1 wt% BTPOS. The mixture is stirred on a hot plate at a temperature of 40 °C for 8 hours until all compounds have dissolved. The solubility of the Irgacure initiator was lower than that of benzil. The relative concentration of BTPOS was chosen to be constant. All photoresist compositions or photoresists were mixed and polymerized in yellow-light conditions.

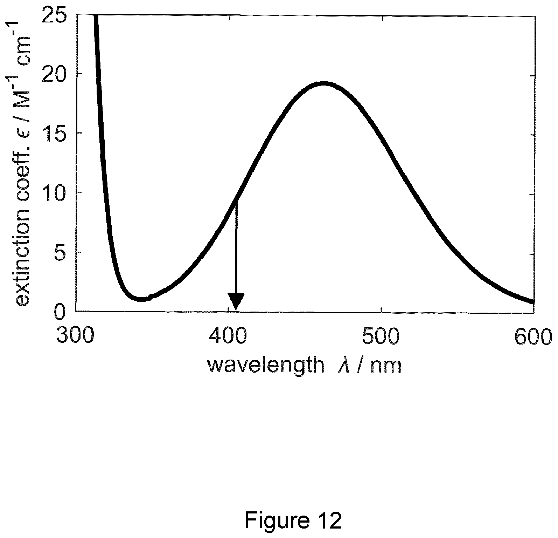

Benzil (98%) was purchased from Aldrich. Bis(2,2,6,6-tetramethyl-4-piperidyl-1-oxyl) sebacate (BTPOS, 98%) was purchased from TCI chemicals. A ground state extinction spectrum is given in Fig. 12. Pentaerythritol triacrylate (PETA) was purchased from Sigma-Aldrich. IP-DIP NPI was purchased from Nanoscribe GmbH & Co. KG. Trimethylolpropane triacrylate (TMPTA, 93%) was purchased from Alfa Aesar. Irgacure 369 was purchased from Ciba Specialty Chemicals.

To connect the behavior of our photoresist compositions with the modelling for two-step absorption in Fig. 2, especially to Fig. 2e, we have performed systematic point-exposure experiments as described herein to investigate the dependence of the threshold laser power *P* = *P*ₜₕ (which, for fixed focusing conditions, is proportional to the threshold laser intensity *I*) and the exposure time *t* = *t*ₑₓₚ.

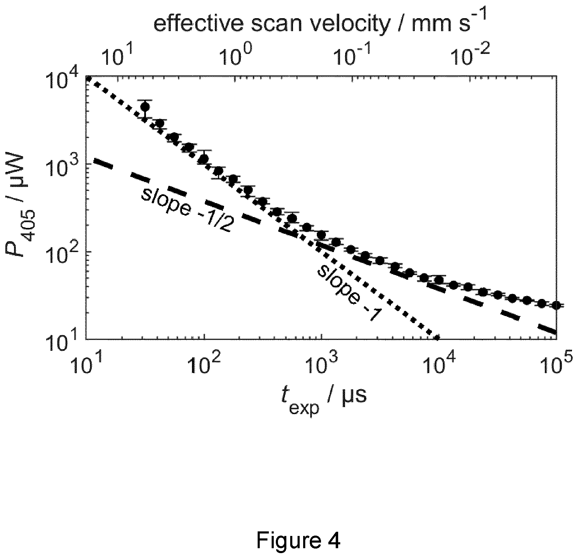

Fig. 4 shows the effective nonlinearity of a photoresist composition according to an embodiment of the present invention. Fig. 4 shows the measured threshold laser power versus exposure time (dots) on a double-logarithmic scale for the photoresist composition PR1. The error bars mark the minimum and maximum values of at least three independent measurements.

For the experiments shown in Fig. 4, we focus the light with a 100× oil-immersion microscope objective lens with numerical aperture NA 1.4 as described above. The aspect ratio of 2.5 of the axial and lateral intensity FWHM indicates a diffraction-limited laser focus. The results of the point-exposure experiments on two-step absorption are plotted as dots on a double-logarithmic scale in Fig. 4. The straight lines with the indicated slopes are guides to the eye. The observed behavior agrees with the behavior for the energy-level model shown in Fig. 2e. In particular, we find a change in slope from -1/2 to -1 at an exposure time of *t*ₑₓₚ ≈ 800 µs or *t*ₑₓₚ*k*_{D} ≈ 10, corresponding to an intermediate-state lifetime of *τ* = *k*_{D}⁻¹ ≈ 80 µs. Outside of the two-step absorption model, one could have interpreted this change in slope as being due to the transition from two-photon absorption to one-photon absorption. However, in our two-step absorption modelling, as discussed above, we have *N* = 2 despite this change of slope. This means that our experimental findings are consistent with two-step absorption, but we cannot rule out one-photon absorption from these data alone.

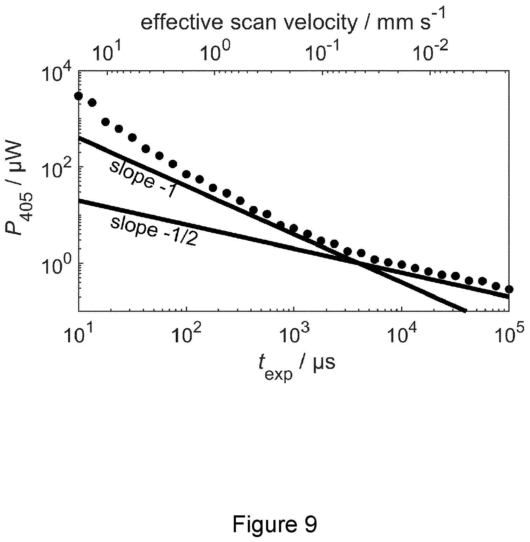

In fact, in control experiments on photoinitiators for which it is established that one gets one-photon absorption at the considered wavelength, we find changes in the slope as well. Corresponding experiments for Irgacure 369 are shown in Fig. 9. They were performed under otherwise similar conditions as the experiments using benzil as the photoinitiator. We interpret the change in slope in Fig. 9 as the onset of chemical nonlinearities in addition to one-photon absorption.

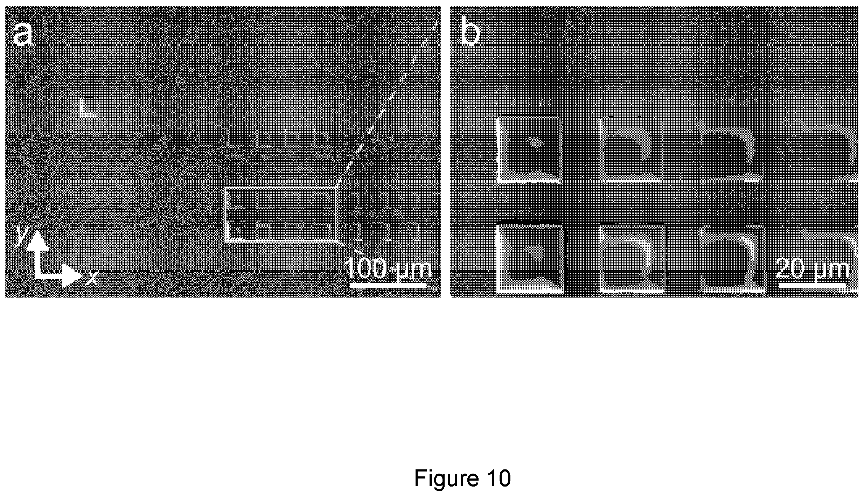

In general, one cannot draw conclusions from point-exposure experiments alone, regardless of the excitation mechanism. Consider the following example: A complex dense 3D structure requires many sequential point exposures. The tails of the laser focus excite photoinitiator molecules in a volume that is much larger than that of the printed structure. This generally means that ingredients of the photoresist, especially oxygen, are locally irreversibly consumed during the printing process. Diffusion of these molecules leads to a global reduction of their density. Thereby, a single point exposure influences even remotely separated other point exposures, giving rise to the proximity effect. Indeed, we are essentially unable to 3D-print structures using Irgacure 369, as shown in Fig. 10. We therefore now turn to discussing our 3D-printing experiments using benzil.

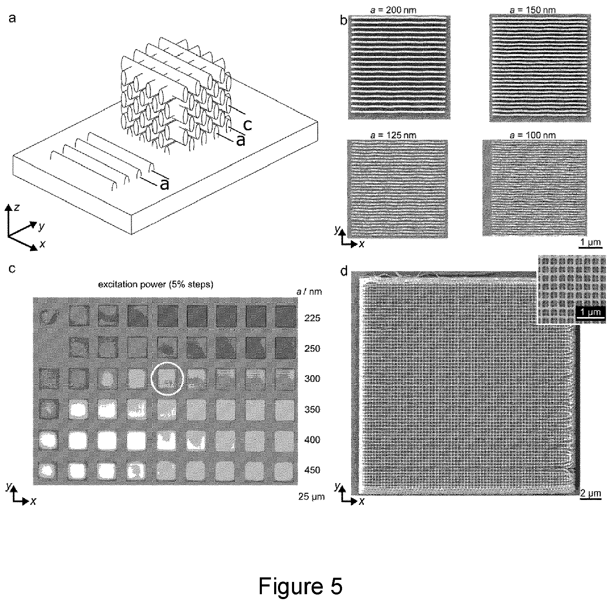

Fig. 5 shows a two-step absorption printing resolution in two and three dimensions. Fig. 5a shows a scheme of 2D line grating with period *α* and a 3D woodpile structure, composed of stacked orthogonal layers of 2D line gratings with lateral period *α* and axial period *c* = √2 *α.* Fig. 5b shows a scanning electron micrograph of printed 2D line gratings. Periods below *α* = 150 nm are realized here. Fig. 5c shows grayscale optical reflection-mode micrographs (objective lens numerical aperture NA 0.4) of a set of 3D woodpile structures. The used laser power is increased in steps of 5% in the horizontal direction. This (partly) leads to underexposed structures on the left and (partly) leads to overexposed structures on the right. The rod spacing *α* is varied along the vertical direction. Fig. 5d shows a top-view scanning electron micrograph of the woodpile with *α* = 300 nm (encircled in Fig. 5d). For comparison, the smallest rod spacing for 3D woodpiles made by using two-photon absorption and near infrared femtosecond lasers is equal to 375 nm (without invoking stimulated-emission depletion). Corresponding commercial instrumentation has allowed high-quality 3D woodpile rod spacings not smaller than 500 nm. All structures displayed are 3D-printed with a scan velocity *ν* = 0.1 mm/s and the photoresist composition PR1.

In two dimensions, dense periodic line gratings (see Fig. 5a) are an established benchmark structure to evaluate the spatial resolution of a lithographic or printing approach. Resolution must not be confused with the minimum achievable line width of an isolated line. In the experiments based on two-step absorption using 405 nm wavelength shown in Fig. 5b, we achieve a minimum grating period *α* or resolution of well below 150 nm, which surpasses previous best values obtained with stimulated-emission depletion (STED) based multiphoton 3D laser nanoprinting at around 800 nm fundamental wavelength. More importantly, in three dimensions, woodpile photonic crystals (see Figs. 5c, d, and e) with 24 layers along the z-direction serve the same purpose as line gratings in two dimensions. Each layer in this three-dimensional stack is a simple line grating with period or pitch *α* in the *xy*-plane. Woodpiles are a demanding relevant benchmark because they contain a dense pattern that is periodic in all three dimensions. Thereby, possible accumulation or proximity effects arising from the tails of the tight laser focus (see above) are revealed - if they are problematic. No indications of severe proximity effects can be observed in the scanning electron micrographs in Fig. 5. Furthermore, the quality and homogeneity of the woodpiles can easily and intuitively be assessed by their optical color under white-light illumination in reflection mode. Grayscale-converted photographs thereof can be seen in Fig. 5c. We note that the laser powers of about 45 µW used at a focus speed of *ν* = 0.1 mm/s (or 485 voxels/s, assuming a voxel size of 206 nm, which is the average of axial and lateral rod size) for the results shown in Figs. 5c and d are somewhat lower than what one would expect from the pointexposures in Fig. 4 at that speed. This difference is due to the proximity effect in the dense 3D woodpile structures in Fig. 5, which effectively lowers the polymerization threshold by about a factor of two with respect to the point exposures under these conditions. Summarizing the results in Fig. 5, the spatial resolution of 3D laser nanoprinting based on two-step absorption at 405 nm wavelength matches that of two-photon absorption combined with STED at about 800 nm wavelength.

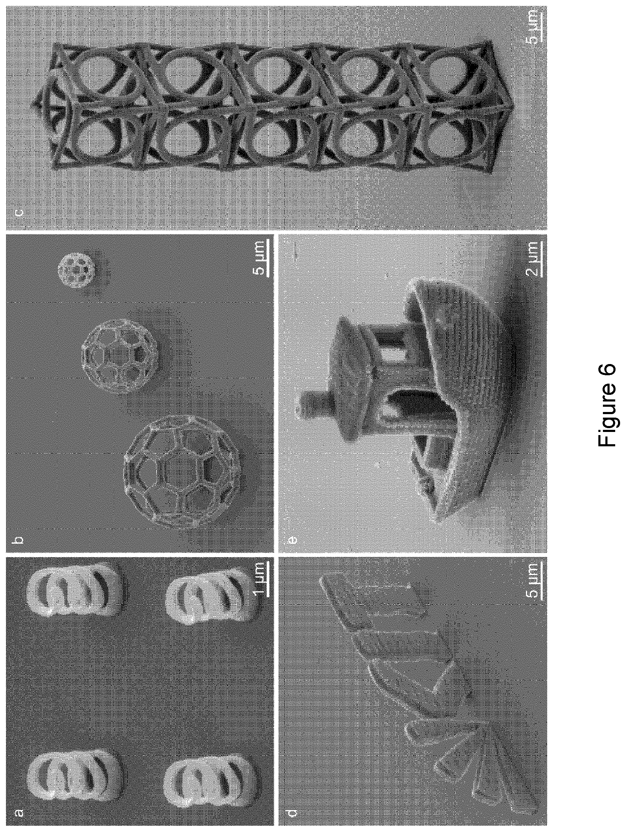

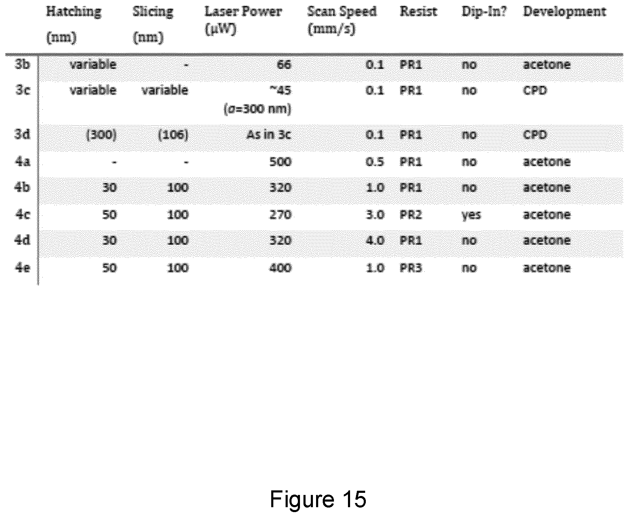

Fig. 6 shows a gallery of oblique-view electron micrographs of 3D-printed nanostructures. Fig. 6a shows helices with a radius of 800 nm and a pitch of 800 nm. Fig. 6b shows three buckyball models with diameters of 15 µm, 10 µm, and 5 µm. Fig. 6c shows five stacked chiral metamaterial unit cells with a lattice constant of 16 µm. Fig. 6d shows a 3D model of the KIT-Logo. Fig. 6e shows a miniaturized model of the #3DBenchy structure. Detailed 3D-printing parameters for all structures are provided in Fig. 15.

In Fig. 6, we present a gallery of electron micrographs of other 3D-printed architectures. Some of these microstructures are intentionally taller than the nanostructures shown in Fig. 5. Thereby, Fig. 6 shows that combining two-step absorption with the widespread immersion or dip-in mode of 3D laser nanoprinting is readily possible. Clearly, dip-in 3D-printing requires that the refractive index of the two-step absorption photoresist PR2 is matched to that underlying the design of the microscope objective lens. We note, however, that fast 3D-printing of structures with a high filling fraction, as in Fig. 6e, is challenging for the photoresist PR2 and even for the photoresist PR1. We attribute this to a higher concentration of abstractable hydrogen atoms within the used monomer. In Fig. 6, the printing laser-focus velocities are around 0.5 to 4 mm/s (or 2 400 to 19 400 voxels/s).

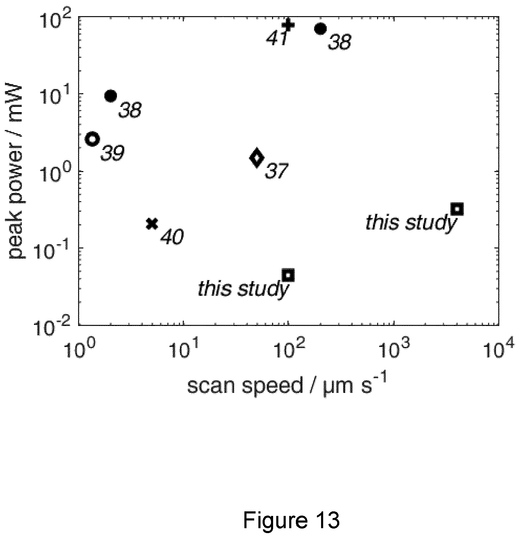

It is interesting to compare the scan speeds and laser powers used in two-step absorption with previous work on 3D laser printing using (quasi-)continuous-wave lasers exploiting one-photon absorption and chemical nonlinearities or two-photon absorption. Fig. 13 compares these studies to the present one. Two-step absorption enables scan speeds that are up to three orders of magnitude faster than in previous studies, and (peak) laser powers that are up to three orders of magnitude lower. Furthermore, we achieve a spatial resolution that is far superior to most of these and that matches previous best results using STED-inspired two-photon 3D laser nanoprinting.

In conclusion, two-step absorption in benzil replacing two-photon absorption may be considered as the fundamental photoinitiation mechanism in 3D laser nanoprinting. The presented 2D and 3D benchmark nanostructures match or even surpass previous results obtained with two-photon absorption in terms of achievable spatial resolution. More importantly, our two-step absorption results were obtained with a continuous-wave semiconductor laser diode that is many orders of magnitude less expensive and smaller in volume than the femtosecond lasers commonly used today for obtaining efficient two-photon absorption. Moreover, for two-step absorption, we have not once observed an indication of micro-explosions. Unwanted photoresist micro-explosions typically occur every day when using two-photon absorption and femtosecond pulses in 3D laser nanoprinting.

The present inventors consider two-step absorption replacing two-photon absorption in 3D laser nanoprinting as a breakthrough. First, it paves the way to cutting down the cost of future 3D laser nanoprinters by several orders of magnitude - while maintaining and even surpassing the accessible spatial resolution, albeit currently at lower peak printing rates than best values obtained for two-photon absorption. Second, dramatic miniaturization of 3D laser nanoprinters is straightforward given that the diode laser used here has a volume of only some cubic millimeters. Combined, the drastic cost and size reduction will likely dramatically amplify the spread of 3D laser nanoprinters in the industrial field in the upcoming years. Third, by combining STED and two-step absorption, the achievable spatial resolution could be further improved, even beyond the diffraction barrier. Fourth, replacing one-photon absorption by two-step absorption could improve the spatial resolution in computed axial lithography. Furthermore, two-step absorption with two different laser colors is a prerequisite for light-sheet 3D laser printing. Both have the potential to boost 3D-printing speed.

Fig. 7 shows a chemical structure of bis(2,2,6,6-tetramethyl-4-piperidyl-1-oxyl) sebacate (BTPOS).

Fig. 8 shows scanning electron micrographs of 3D-printed line gratings with different grating periods when omitting the quencher BTPOS in the photoresist composition PR1 containing benzil. The fast scanning direction is along the -*x* direction, the slow scanning direction is along the +*y* direction. The used laser powers are about 2 µW. All other 3D-printing parameters are identical to the line gratings shown in Fig. 5. These results show that the polymerization inhibitor is an essential ingredient in the studied photoresist compositions for making two-step absorption a suitable excitation mechanism for 3D laser nanoprinting.

Fig. 9 shows laser power versus exposure time for the photoresist PR4, containing Irgacure 369 (50 mM) instead of benzil. The straight lines are guides to the eye. For exposure times *t*ₑₓₚ > 4 ms, the data are consistent with a slope of -1/2. For exposure times *t*ₑₓₚ < 100 µs, the data indicate a slope close to -1.

Fig. 10 shows a top-view scanning electron micrograph of attempts to 3D-print woodpile structures using the photoresist PR4, containing Irgacure 369 as the photoinitiator. Fig. 10a shows an overview image. The structures have been printed from top left to bottom right. Fig. 10b shows a zoom-in of Fig. 10a. The threshold dose increases in the proximity of previously 3D-printed structures. These results show that 3D laser nanoprinting is essentially impossible when replacing benzil (supporting two-step absorption) by Irgacure 369 (supporting one-photon absorption) as the photoinitiator.

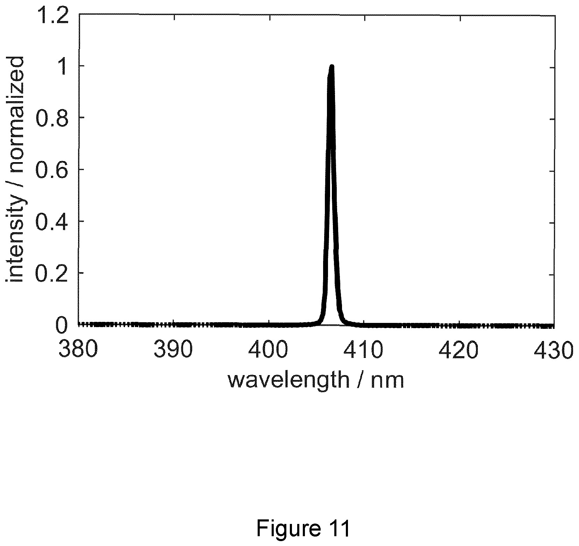

Fig. 11 shows a spectrum of the laser diode emission at the operating temperature of *T*_{Diode} = 25 °C. The peak wavelength is at *λ*_{P} = 406.5 nm, which is slightly red-shifted from the diode's nominal wavelength of *λ* = 405 nm.

Fig. 12 shows a ground state extinction spectrum of BTPOS in acetonitrile. The arrow indicates the excitation wavelength.

Fig. 13 shows an overview on a double-logarithmic scale of 3D laser polymer printing using (quasi-)continuous-wave lasers. It can be seen that two-step absorption (labelled as "this study") enables scan speeds that are up to three orders of magnitude faster than in previous studies (numbers 37 to 41), and (peak) laser powers that are up to three orders of magnitude lower. Note that this overview does not include the achieved spatial resolution.

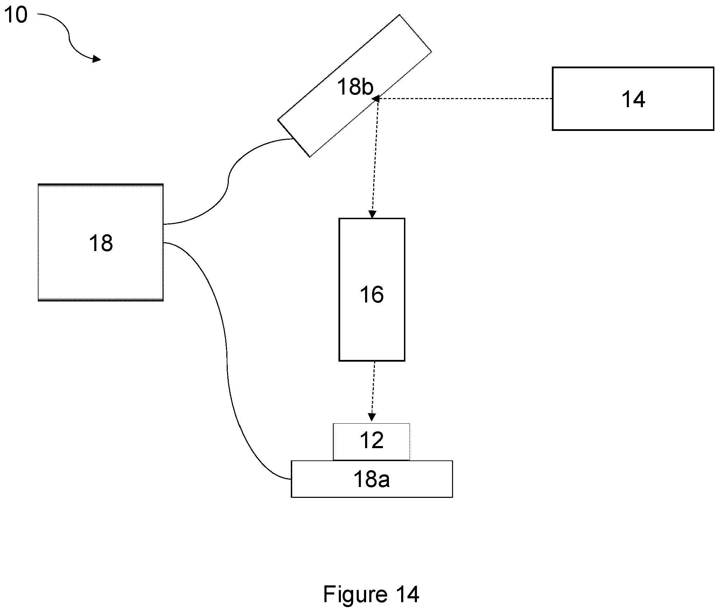

In Fig. 14, a very simplified schematic picture of a system 10 is shown. The system 10 comprises a photoresist composition 12, a continuous-wave light source 14, a focusing unit 16, and a positioning unit 18 comprising a movable stage 18a and a tiltable mirror 18b. The continuous-wave light source 14 may be a laser diode. The dashed arrow line represents the optical path of the light emitted by the continuous-wave light source 14.

In a more specific embodiment (not shown), the laser diode (L405P150, Thorlabs GmbH) is mounted on a temperature-controlled mount (LDM56/M, Thorlabs GmbH). A spectrum of the laser emission is displayed in Fig. 11. The diode's temperature is controlled by a TEC controller (TED200C, Thorlabs GmbH) and the electrical current is controlled using a laser diode driver (LDC 200, Profile GmbH). An aspheric 8 mm focal length collimator lens (A240TM-A, Thorlabs GmbH) collimates the laser diode output. The laser diode's beam is focused using a 40 mm focal length plano-convex (LA1422-A, Thorlabs GmbH) lens through a 10 µm diameter pinhole (P10C Thorlabs GmbH) and collimated by a 75 mm focal length achromatic lens (AC254-075-A, Thorlabs GmbH). The beam is deflected by a pair of galvanometric mirrors (Saturn 5B 56S, Pangolin Laser Systems Inc.) which are imaged by two achromatic lenses (ACL254-100-A and ACL254-150-A, Thorlabs GmbH) through a quarter-wave plate (WPQSM05-405, Thorlabs GmbH) on a microscope objective lens' (HCX PL APO 100×/1.4-0.7 Oil CS, Leica Microsystems GmbH) entrance pupil. For 3D-printing the woodpile structures, no quarter-wave plate was used. The objective lens focusses the beam into the sample photoresist (25 µl), which, for non-dip-in experiments, is contained in a PDMS-ring (5 mm diameter) placed on a methacrylate silanized glass coverslip (No. 1.5H, Paul Marienfeld GmbH & Co. KG). The coverslip is mounted on a 3D piezoelectric stage (P-527.3CL, Physik Instrumente GmbH & Co. KG). For 3D-printing the structures in Fig. 6c and 6e, the piezoelectric stage was replaced by one with a larger travel range (P-563.3CD, Physik Instrumente GmbH & Co. KG). Galvanometric xy-scanning was used for all 3D structures shown in Fig. 6. All other structures were 3D-printed by scanning the sample with the piezoelectrically actuated stages.

During 3D-printing, the sample is illuminated using an LED with a peak wavelength *λ* ≈ 640 nm and observed in-situ in transmission-mode on a CCD camera.

The laser power was adjusted using a half-wave plate (WPHSM05-405, Thorlabs GmbH) and a polarizing beamsplitter cube (PBS251, Thorlabs GmbH), both located in front of the galvanometric mirror pair. In order to probe exposure powers even below the lowest possible power setting permitted by the half-wave plate and the beamsplitter, absorptive neutral density glass filters (FSQ-OD20 to FSQ-OD300, Coherent Inc.) were placed behind the polarizing beamsplitter cubes. The laser focus was checked routinely to ensure that the filter glass does not cause any wavefront aberrations.

All laser power values were measured at the objective lens' entrance pupil location using a semiconductor sensor (TP86, Coherent Inc.). For the point-exposure measurements, the pulses were monitored using an avalanche photodiode (APD410A/M, Thorlabs GmbH) placed at the idle output of the polarizing beamsplitter cube.

All samples except the woodpile photonic crystals were developed by immersing the sample for 3 minutes in a bath of acetone (UV/IR grade) and a subsequent wash in 2-propanol (UV/IR grade). The samples were then blow-dried in a gentle stream of nitrogen.

The woodpile photonic crystals were developed in acetone (UV/IR grade) with subsequent supercritical drying in CO₂ using the EM CPD300 (Leica Microsystems GmbH).

Fig. 15 shows a list of 3D-printing parameters for all structures shown in Figs. 1 to 6. In the "Development" column, "CPD" stands for "Critical Point Drying".

Summing up, the quadratic optical nonlinearity arising from two-photon absorption provides the crucial spatial concentration of optical excitation in 3D laser nanoprinting, with widespread applications in the technical and life sciences. Femtosecond lasers allow for obtaining efficient two-photon absorption but are accompanied by a number of issues, including higher-order processes, cost, reliability, and size.

The present inventors have recognized that involving at least two sequential single-photon excitations or two-step photon absorption replacing two-photon absorption as the primary optical excitation process may overcome the above-mentioned issues and drawbacks of state-of-the-art 3D-printing. Two-step absorption may enable the same quadratic optical nonlinearity as two-photon absorption. Hence, the present invention allows for printing state-of-the-art 3D nanostructures and beyond with high resolution and opens the door to drastic miniaturization and cost cutting of 3D-printing.

### List of Reference Numerals

- 10: system
- 12: photoresist composition
- 14: continuous-wave light source
- 16: focusing unit
- 18: positioning unit
- 18a: stage
- 18b: mirror

## Claims

1. A photoresist composition, comprising:
(A) a polymerizable monomer,
(B) a photoinitiator, and optionally
(C) a polymerization inhibitor,
wherein the photoinitiator has at least the following electronic quantum mechanical energy states:
(i) a ground state,
(ii) a substantially optically excitable first intermediate state, and
(iii) an optically excitable polymerization-inducing state,
wherein the first intermediate state is energetically located above the ground state and below the polymerization-inducing state and has a lifetime of about 100 ps to 10 s, and
the polymerization-inducing state is optically excitable from the first intermediate state by a single-photon excitation of a predetermined wavelength.

2. The photoresist composition according to claim 1, wherein the polymerization-inducing state is optically excitable by at least two sequential single-photon excitations of substantially the same predetermined wavelength.

3. The photoresist composition according to claim 1 to 2, wherein the predetermined wavelength is at least about 300 nm and/or utmost about 900 nm, in particular at least about 400 nm and/or utmost about 800 nm.

4. The photoresist composition according to any one of claims 1 to 3, wherein the first intermediate state is a relaxed state with respect to an energetically higher state being optically excitable from the ground state by a single-photon excitation.

5. The photoresist composition according to any one of claims 1 to 4, wherein the photoinitiator is selected from the group consisting of alpha-diketones, beta-diketones, gamma-diketones, spiropyrans, merocyanines, carbazoles, thiophenes, polycyclic aromatic hydrocarbons, triketones, photoenoles, (di-)acylgermanes, bis(germyl)ketones, and thioxanthones.

6. The photoresist composition according to any one of claims 1 to 5, wherein the polymerization inhibitor is selected from the group consisting of 2,2,6,6-tetramethyl-4-piperidyl-1-oxyl (TEMPO) and derivatives thereof, bis(2,2,6,6-tetramethyl-4-piperidyl-1-oxyl) sebacate (BTPOS) and derivatives thereof, other hindered amine light stabilizers (HALS), 1,4-diazabicyclo[2.2.2]octane (DABCO), n-propyl gallate (NPG), p-phenylenediamine (PPD), cyclodextrines, phenothiazines, hydroxylamines, quinones, mequinol, 4-tert-butylcatechol (TBC), butylated hydroxytoluene (BHT), nitrobenzenes, phenol, p-nitrophenol, stilbenes, galvinoxyl, and azulene.

7. The photoresist composition according to any one of claims 1 to 6, wherein the content of the photoinitiator is 0.1% to 10% by weight based on the photoresist composition and/or the content of the polymerization inhibitor is 0.05% to 10% by weight based on the photoresist composition.

8. A system, in particular for 3D-printing, comprising:
a photoresist composition according to any one of claims 1 to 7, and
at least one continuous-wave light source for irradiating the photoresist composition,
the system optionally further comprising:
a focusing unit for focusing the light emitted by the at least one continuous-wave light source on the photoresist composition, and
a positioning unit for controlling the position of the focusing unit with respect to the position of the photoresist composition.

9. The system according to claim 8, wherein the at least one continuous-wave light source comprises a laser and/or a light emitting diode.

10. The system according to claim 8 or 9, wherein the light emitted by the at least one continuous-wave light source has a wavelength of at least about 300 nm and/or utmost about 900 nm, in particular of at least about 400 nm and/or utmost about 800 nm.

11. The system according to any one of claims 8 to 10, wherein the at least one continuous-wave light source has an optical power of about 1 mW or larger.

12. A method for producing a three-dimensional structure, wherein the method comprises the following steps:
providing a photoresist composition according to any one of claims 1 to 7, and
causing polymerization in at least a partial volume of the photoresist composition by irradiating the at least partial volume by means of at least one continuous-wave light source.

13. The method according to claim 12, wherein the method further comprises:
removing an unpolymerized and/or incompletely polymerized remaining volume of the photoresist composition,
wherein the polymerized at least partial volume of the photoresist composition corresponds to the three-dimensional structure.

14. The method according to claim 12 or 13, wherein the step of causing polymerization further includes:
exciting the polymerization-inducing state of the photoinitiator by at least two sequential single-photon excitations of substantially the same predetermined wavelength.

15. Use of a photoresist composition according to any one of claims 1 to 7 in 3D-printing.
